# EUROPÄISCHE PATENTANMELDUNG

(11) **EP 4 306 854 A1**
(43) Veröffentlichungstag der Anmeldung: **17.01.2024**
(21) Anmeldenummer: 23179345.6
(22) Anmeldetag: 14.06.2023
(51) Int. Cl.: F24C 7/08, H05B 6/12

(54) **VERFAHREN ZUM BETRIEB EINES KOCHFELDS UND DAFÜR AUSGEBILDETES KOCHFELD**

(30) Priorität: 12.07.2022 DE 102022207122
(71) Anmelder: E.G.O. Elektro-Gerätebau GmbH, 75038 Oberderdingen (DE)
(72) Erfinder: Gässler, Sandra, 71665 Vaihingen an der Enz (DE); Walk, Peter, 76133 Karlsruhe (DE)
(74) Vertreter: Patentanwälte Ruff, Wilhelm, Beier, Dauster & Partner mbB

(57) **Zusammenfassung**

Ein Kochfeld mit einer Bedieneinrichtung mit Bedienelementen mit kapazitiven Sensorelementen weist eine Steuereinrichtung auf, die dazu ausgebildet ist, eine Wischschutz-Funktion zu bieten, die von einer Bedienperson aktivierbar und deaktivierbar ist. Sie bewirkt, dass nach ihrem Aktivieren Sensorsignale von den Sensorelementeinrichtungen von der Bedieneinrichtung nicht in Bedienbefehle umgesetzt werden. Die Wischschutz-Funktion wird erst dann von der Bedieneinrichtung selbsttätig wieder deaktiviert, wenn nach ihrem Aktivieren und seit dem letzten Erkennen einer Bedienung an mindestens einer der Sensorelementeinrichtungen oder seit dem letzten Empfangen eines Sensorsignals von mindestens einer der Sensorelementeinrichtungen eine Wartedauer von 0 sec bis 20 sec abgelaufen ist ohne erneutes Erkennen einer Bedienung oder Empfangen eines Sensorsignals.

## Beschreibung

### ANWENDUNGSGEBIET UND STAND DER TECHNIK

Die Erfindung betrifft ein Verfahren zum Betrieb eines Kochfelds sowie ein zur Durchführung dieses Verfahrens ausgebildetes Kochfeld.

Aus der DE 102010062745 A1 ist eine sogenannte Wischschutz-Funktion für ein Kochfeld bekannt. Diese dient dazu, Bedienelemente einer Bedieneinrichtung des Kochfelds für eine gewisse Zeit zu deaktivieren, sodass in dieser Zeit übergelaufenes flüssiges Kochgut nicht stört, oder mit einem feuchten Lappen die Oberfläche des Kochfelds über den Bedienelementen reinigen zu können. Bei Bedienelementen, die ein kapazitives Funktionsprinzip haben wie beispielsweise entsprechend der EP 859467 A1 und der EP 859468 A1, stört Flüssigkeit bzw. Feuchtigkeit als Film über den Bedienelementen, da dies nicht immer unbedingt sauber von einer gewünschten Bedienung mit einem Finger unterschieden werden kann. Deswegen bewirkt das Aktivieren der Wischschutz-Funktion über ein dafür vorgesehenes Bedienelement sozusagen ein Deaktivieren der Bedienelemente der Bedieneinrichtung. Die Wischschutz-Funktion kann ggf. bei entsprechender Ausgestaltung von der Bedienperson entweder gezielt manuell aufgehoben bzw. deaktiviert werden, also indem das dafür vorgesehene Bedienelement erneut bedient wird, oder die Wischschutz-Funktion wird nach einer fest vorgegebenen Zeit selbsttätig deaktiviert. Im ersten Fall wird eine erneute Bedienung von der Bedienperson gefordert. Im zweiten Fall kann der Zeitpunkt des Deaktivierens der Wischschutz-Funktion unpassend sein und die Bedienperson in der Bedienung behindern oder bei einem noch andauernden Wischvorgang Fehler produzieren.

### AUFGABE UND LÖSUNG

Der Erfindung liegt die Aufgabe zugrunde, ein eingangs genanntes Verfahren zum Betrieb eines Kochfelds sowie ein zur Durchführung dieses Verfahrens ausgebildetes Kochfeld zu schaffen, mit denen Probleme des Standes der Technik gelöst werden können und es insbesondere ermöglicht wird, ein Kochfeld sicher und praxistauglich betreiben und bedienen zu können bei möglichst hoher Bediensicherheit und möglichst hohem Bedienkomfort.

Gelöst wird diese Aufgabe durch ein Verfahren mit den Merkmalen des Anspruchs 1 sowie durch ein Kochfeld mit den Merkmalen des Anspruchs 11. Vorteilhafte sowie bevorzugte Ausgestaltungen der Erfindung sind Gegenstand der weiteren Ansprüche und werden im Folgenden näher erläutert. Dabei werden manche der Merkmale nur für das Verfahren oder nur für das Kochfeld beschrieben. Sie sollen jedoch unabhängig davon sowohl für ein Verfahren als auch für ein Kochfeld selbständig und unabhängig voneinander gelten können. Der Wortlaut der Ansprüche wird durch ausdrückliche Bezugnahme zum Inhalt der Beschreibung gemacht.

Bei dem Verfahren zum Betrieb eines Kochfelds weist das Kochfeld eine Kochfeldplatte, Heizeinrichtungen an der Kochfeldplatte und eine Bedieneinrichtung an oder unter der Kochfeldplatte auf. Die Bedieneinrichtung weist mehrere Sensorelementeinrichtungen unter der Kochfeldplatte auf, um das Vorhandensein eines Fingers oberhalb einer der Sensorelementeinrichtungen auf der Oberseite der Kochfeldplatte für eine Bedienung zu erkennen, wobei vorteilhaft die Sensorelementeinrichtungen kapazitive Sensorelemente für die Bedienelemente aufweisen. Die Sensorelementeinrichtungen sind auch dazu ausgebildet, eine Bedienung und ggf. auch das Vorhandensein von Flüssigkeit oberhalb einer Sensorelementeinrichtung auf der Oberseite der Kochfeldplatte zu erkennen. Ausgehend von dieser Erkennung können Sensorsignale erzeugt werden, wobei hierfür auch eine damit zusammenwirkende Steuereinrichtung vorgesehen ist. Vorteilhaft ist sie die Steuereinrichtung der Bedieneinrichtung selbst. Ein Erkennen von Flüssigkeit oberhalb einer Sensorelementeinrichtung ist dann möglich, wenn mehrere nebeneinanderliegende Sensorelemente gleichzeitig Sensorsignale erzeugen, wie wenn sie bedient worden wären, also wenn sie gleichzeitig als bedient gelten.

Erfindungsgemäß weist die Bedieneinrichtung eine Wischschutz-Funktion auf, die von einer Bedienperson aktivierbar ist und sich selbsttätig deaktiviert, möglicherweise kann sie auch an der Bedieneinrichtung selbst deaktiviert werden. Die Wischschutz-Funktion ist derart ausgebildet, dass nach Aktivieren der Wischschutz-Funktion Sensorsignale von den Sensorelementeinrichtungen oder entsprechenden Bedienelementen von der Bedieneinrichtung nicht in Bedienbefehle umgesetzt werden oder keine Bedienung bewirken, also quasi blockiert oder ignoriert werden. Die Wischschutz-Funktion wird erst dann von der Bedieneinrichtung selbsttätig wieder deaktiviert, wenn nach Aktivieren der Wischschutz-Funktion seit dem letzten Erkennen einer Bedienung an mindestens einer der Sensorelementeinrichtungen oder seit dem letzten Empfangen eines Sensorsignals von mindestens einer der Sensorelementeinrichtungen, welches anzeigt, dass ein Finger oder Flüssigkeit auf der Oberseite der Kochfeldplatte oberhalb einer der Sensorelementeinrichtungen erkannt worden ist, eine vorgegebene Wartedauer von 0 sec oder 0,1 sec bis 20 sec abgelaufen ist ohne dass erneut eine Bedienung oder ein Empfangen eines Sensorsignals genau dieser Sensorelementeinrichtung oder einer beliebigen anderen Sensorelementeinrichtung erkannt worden ist. Vorteilhaft kann die Wartedauer 1 sec bis 5 sec oder bis 10 sec dauern. Sie kann möglicherweise von einer Bedienperson auch verändert werden, beispielsweise in einem speziellen Einstellmenü. Wird erneut solchermaßen eine Bedienung oder ein Empfangen eines Sensorsignals erkannt innerhalb der Wartedauer bzw. vor deren Ablauf erkannt, so ist die Wischschutz-Funktion wieder erneut aktiviert und die Wartedauer beginnt erneut zu laufen, sobald wieder keine Bedienung oder ein Empfangen eines Sensorsignals erkannt worden ist. Wird nach Aktivieren der Wischschutz-Funktion keine Sensorelementaktivität festgestellt, so wird die Wischschutz-Funktion nach einer voreingestellten Timeout-Zeit dennoch deaktiviert, damit die Bedienperson beim nächsten Bedienen nach versehentlichem Aktivieren keine unangenehmen Wartezeiten hat. Der Timer nach erkannter Sensorelementaktivität und der Timeout-Timer, falls gar kein Sensorsignal erkannt wird, können identisch sein oder aber auch sich unterscheiden.

So kann eine Art automatisiertes oder selbst bewirktes Ende der Wischschutz-Funktion bewirkt werden, wenn sie faktisch nicht mehr benötigt wird. Die Bedienperson muss sie dann nicht mehr zwingend beenden. Möglicherweise kann die genannte Wartedauer von einer Bedienperson allgemein in einer Grund-Menüeinstellung des Kochfelds bzw. der Steuereinrichtung verändert werden. Dies kann insbesondere in eine Richtung bzw. in eine Wartedauer sein, die die Bedienperson aufgrund ihrer eigenen Erfahrung als praxistauglich und gewünscht ansieht.

In möglicher Ausgestaltung der Erfindung kann die Wischschutz-Funktion für sämtliche Sensorelementeinrichtungen der Bedienvorrichtung gelten bis auf eine Sensorelementeinrichtung für eine Ein-/Ausschalt-Funktion des Kochfelds derart, dass eine Bedienung an dieser Sensorelementeinrichtung immer zum Einschalten oder Ausschalten des Kochfelds führt. Dies ist vorzugsweise unabhängig davon, ob sie alleine oder gleichzeitig mit weiteren Sensorelementeinrichtungen bedient worden ist oder ob Sensorsignale von weiteren Sensorelementeinrichtungen empfangen worden sind. In möglicher Weiterbildung der Erfindung kann auch ein Bedienelement bzw. ein Schalter zum Aktivieren und/oder Deaktivieren der Wischschutz-Funktion von der Wischschutz-Funktion selbst ausgenommen sein. So kann eine Bedienperson die Wischschutz-Funktion sozusagen immer deaktivieren.

In vorteilhafter Ausgestaltung der Erfindung ist es möglich, dass ein Aktivieren der Wischschutz-Funktion von der Bedieneinrichtung signalisiert wird, insbesondere akustisch und/oder optisch, und zwar egal, wie sie aktiviert worden ist. Besonders vorteilhaft wird akustisch und optisch signalisiert, beispielsweise durch ein Blinken einer Anzeige und einen lauten Piepston oder einen Summton. In ähnlicher Form oder gleicher Form kann ein Deaktivieren der Wischschutz-Funktion von der Bedieneinrichtung signalisiert werden, insbesondere akustisch und/oder optisch. Bevorzugt erfolgt dies gleichartig wie beim Aktivieren der Wischschutz-Funktion.

In einer ersten möglichen Ausbildung der Erfindung kann vorgesehen sein, dass die Wischschutz-Funktion durch Bedienen einer einzigen Sensorelementeinrichtung oder eines einzigen Bedienelements aktiviert werden kann bzw. aktivierbar ist. Das ist eine sehr schnell und leicht durchführbare Aktivierung. Auf entsprechende Art und Weise kann die Wischschutz-Funktion auch durch Bedienen einer einzigen Sensorelementeinrichtung deaktiviert werden, vorteilhaft wenn diese Sensorelementeinrichtung von der Wischschutz-Funktion ausgenommen ist. Ansonsten steht sie zum Deaktivieren nicht zur Verfügung.

In einer zweiten möglichen Ausbildung der Erfindung kann vorgesehen sein, dass die Wischschutz-Funktion durch gleichzeitiges Bedienen von genau zwei oder von mindestens zwei Sensorelementeinrichtungen oder Bedienelementen aktiviert werden kann bzw. aktivierbar ist, alternativ müssen die beiden Sensorelementeinrichtungen in kurzer Zeit hintereinander bedient werden. Vorteilhaft sind diese genau zwei oder von mindestens zwei Sensorelementeinrichtungen oder Bedienelemente dann räumlich nahe beieinander angeordnet, insbesondere in eine oder zwei Richtungen benachbart zueinander. Auch hier kann auf entsprechende Art und Weise die Wischschutz-Funktion durch gleichzeitiges Bedienen von genau zwei oder von mindestens zwei Sensorelementeinrichtungen deaktiviert werden.

In weiterer möglicher Ausgestaltung der Erfindung kann vorgesehen sein, dass nach Ablauf einer Zeit, die 2 sec bis 2 min betragen kann, vorzugsweise 5 sec bis 20 sec, nach Aktivieren der Wischschutz-Funktion ohne Erkennen eines Bedienens an mindestens einer Sensorelementeinrichtung oder Empfangen eines Sensorsignals von mindestens einer Sensorelementeinrichtung, was auf ein Erkennen einer Bedienung oder von Wasser darüber schließen lassen könnte, die Wischschutz-Funktion von der Bedieneinrichtung selbsttätig deaktiviert wird. Vorzugsweise kann vorgesehen sein, dass an mindestens zwei Sensorelementeinrichtungen und nicht an nur einer einzigen Sensorelementeinrichtung kein Bedienen oder Empfangen eines Sensorsignals erfolgt ist. Dies kann die Sicherheit nochmals erhöhen.

In bevorzugter Weiterbildung der Erfindung bleibt die Wischschutz-Funktion nur dann aktiv, wenn innerhalb der vorgenannten Wartedauer nach ihrem Aktivieren nicht nur eine Sensorelementeinrichtung, sondern mindestens zwei Sensorelementeinrichtungen bedient werden oder Sensorsignale von mindestens zwei Sensorelementeinrichtungen, insbesondere gleichzeitig, empfangen werden. Dies erhöht ähnlich wie vorbeschrieben die Sicherheit bzw. stellt sicher, dass ein Vorgang, der einem Wischen mit einem feuchten Lappen oder dem Vorhandensein von Flüssigkeit auf der Kochfeldplatte entspricht oder dadurch hervorgerufen worden ist, erkannt werden kann, insbesondere von einer normalen Bedienung an einer einzigen Sensorelementeinrichtung bzw. an einem einzigen Bedienelement unterschieden werden kann.

Das erfindungsgemäße Kochfeld weist eben eine Kochfeldplatte, Heizeinrichtungen daran und eine Bedieneinrichtung an oder unter der Kochfeldplatte auf. Eine Steuereinrichtung, vorteilhaft ein Controller bzw. Mikrocontroller, ist in der Bedieneinrichtung vorgesehen. So kann die Steuereinrichtung die Sensorelementeinrichtungen ansteuern und auswerten. Vorteilhaft kann noch eine Signaleinrichtung in der Bedieneinrichtung vorgesehen sein, die insbesondere akustische Signale erzeugt. Auch eine optische Anzeige ist vorteilhaft vorgesehen.

Die Sensorelementeinrichtungen der Bedienelemente können dazu ausgebildet sein, eine Bedienung mittels eines Fingers und, gegebenenfalls zusammen mit der Steuereinrichtung und zusätzlichen Sensoren, das Vorhandensein von Flüssigkeit oberhalb einer Sensorelementeinrichtung auf der Oberseite der Kochfeldplatte zu erkennen. Dann erzeugen sie Sensorsignale, welche in der Bedieneinrichtung bzw. von der vorgenannten Steuereinrichtung erkannt und ausgewertet werden. Insbesondere wenn die Wischschutz-Funktion nicht aktiviert ist, werden aus den Sensorsignalen Bedienbefehle erzeugt, und diese dann von der Bedieneinrichtung bzw. der Steuereinrichtung am Kochfeld umgesetzt, insbesondere bezüglich einer Heizleistung an einer der Kochstellen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte und Zwischen-Überschriften beschränkt die unter diesen gemachten Aussagen nicht in ihrer Allgemeingültigkeit.

### KURZBESCHREIBUNG DER ZEICHNUNGEN

Weitere Vorteile und Aspekte der Erfindung ergeben sich aus den Ansprüchen und aus der Beschreibung von Ausführungsbeispielen der Erfindung, die nachfolgend anhand der Figuren erläutert sind. Dabei zeigen:
- Fig. 1: eine Draufsicht auf ein erfindungsgemäßes Kochfeld mit Kochstellen in einem Kochbereich und einer Bedieneinrichtung in einem Bedienbereich,
- Fig. 2: das Kochfeld aus Fig. 1 mit einem vorne links aufgesetzten Topf, aus dem überlaufendes Kochwasser auf Bedienelemente der Bedieneinrichtung ausgetreten ist,
- Fig. 3: eine Situation ähnlich Fig. 2, bei der mit einem feuchten Lappen im Bereich des austretenden Kochwassers gewischt wird,
- Fig. 4: der Zustand nach dem Wischen mit einem feuchten Lappen gemäß Fig. 3, bei dem ein Feuchtebereich oberhalb von einigen Bedienelementen verblieben ist, und
- Fig. 5: ein Zustand kurz nach demjenigen Zustand der Fig. 4, bei dem der feuchte Bereich entweder vollständig verschwunden ist oder aber noch über dem Bedienelement ganz links verbleibt.

### DETAILLIERTE BESCHREIBUNG DER AUSFÜHRUNGSBEISPIELE

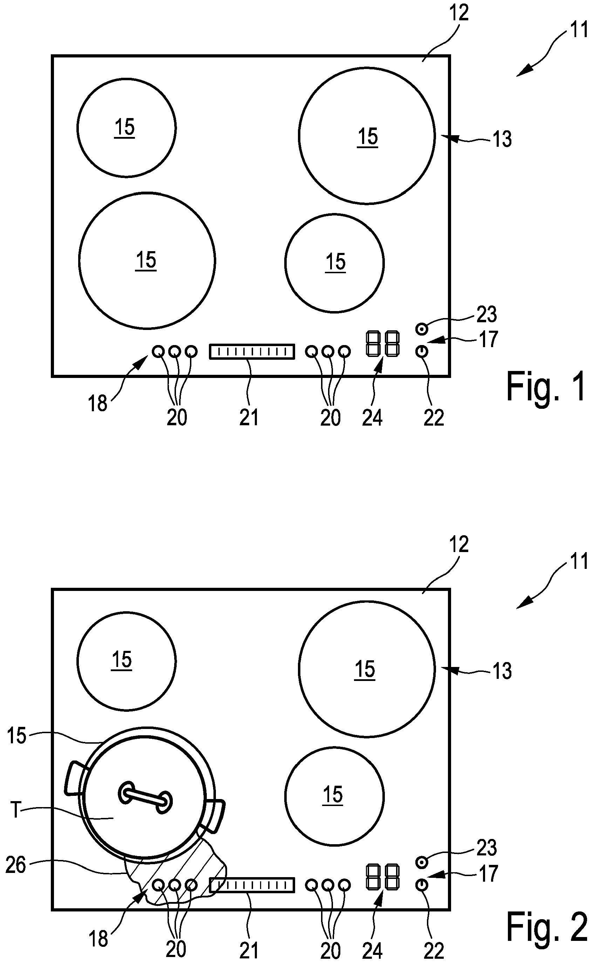

In der Fig. 1 ist ein Kochfeld 11 mit einer Kochfeldplatte 12 dargestellt. Im hinteren und größeren Bereich der Kochfeldplatte 12 ist ein Kochbereich 13 mit vier Kochstellen 15 vorgesehen, welche beispielsweise mittels unter der Kochfeldplatte 12 angeordneter Induktionsheizspulen beheizt werden können. Der vordere Bereich des Kochfelds 11 bildet einen Bedienbereich 17, in dem eine Bedieneinrichtung 18 angeordnet ist. Die Bedieneinrichtung 18 weist mehrere runde Bedienelemente 20, einen mittigen länglichen Slider 21 und einen Ein-/Aus-Schalter 22 auf. Links von diesem ist eine Anzeige 24 angeordnet, beispielsweise als zweistellige Sieben-Segment-Anzeige. Des Weiteren ist ein Wischschutz-Schalter 23 als eines der Bedienelemente vorgesehen. Diese sämtlichen Bedienelemente werden gebildet von Sensorelementeinrichtungen in Form von kapazitiven Sensorelementen unterhalb der Kochfeldplatte 12, wie sie aus dem eingangs genannten Stand der Technik bekannt sind. Die Bedieneinrichtung 18 weist eine nicht dargestellte Steuereinrichtung auf, vorteilhaft ausgeführt als Mikrocontroller, in dem Sensorsignale von kapazitiven Sensorelementen der Bedienelemente ausgewertet werden, und zwar für sich selbst und auch in einem Zusammenhang mit benachbarten Bedienelementen. So kann die Bedieneinrichtung 18 bzw. deren Steuereinrichtung erkennen, ob eine Fehlbedienung vorliegt, beispielsweise ob mehrere Bedienelemente gleichzeitig bedient werden, was aber so nicht vorgesehen ist. Des Weiteren kann, was nachfolgend noch vertieft wird und zuvor bereits beschrieben worden ist, Flüssigkeit oder Wasser oben auf der Kochfeldplatte 12 über der Bedieneinrichtung 18 bzw. den Bedienelementen 20 bis 23 erkannt werden, alternativ auch beispielsweise ein feuchter Lappen.

In der Fig. 2 ist dargestellt, wie auf der Kochstelle 15 vorne links ein Topf T aufgestellt ist, aus dem beispielsweise beim Kochen von Nudeln Kochwasser 26 ausgelaufen ist, welches als Wasserlache auf der Oberfläche der Kochfeldplatte 12 ausgebreitet ist. Wie dargestellt ist, überdeckt der von dem Kochwasser 26 gebildete Wasserfilm die drei Bedienelemente 20 links neben dem Slider 21 und auch diesen auch noch zum Teil. Des Weiteren kann auch noch ein weiterer Bereich der Kochfeldplatte 12 im Kochbereich 13 von dem Kochwasser 26 bedeckt sein, wo dieses aber nicht stört, zumindest nicht eine Bedienung bzw. die Bedieneinrichtung 18.

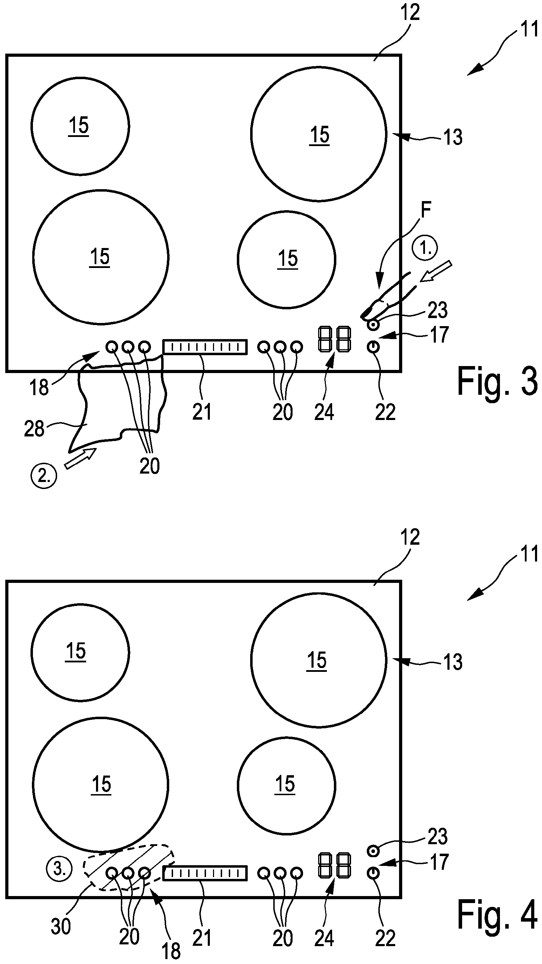

In vorteilhafter Ausgestaltung der Erfindung kann die Steuereinrichtung der Bedieneinrichtung 18 derartiges Kochwasser 26 bereits dann als solches und nicht als Bedienung mit einem aufgelegten Finger F, wie in Fig. 3 dargestellt, erkennen. Auf alle Fälle kann die Steuereinrichtung mit der Bedieneinrichtung 18 und zusammen mit den Bedienelementen 20 bzw. deren kapazitiven Sensorelementen erkennen, wenn das Kochwasser 26 über einem oder über mindestens zwei Bedienelementen 20 bis 23 vorhanden ist. Dann sind diese nämlich durch das elektrisch leitfähige Kochwasser 26 sozusagen in gewissem Maß kapazitiv miteinander gekoppelt. Ein derartiges Erkennen wird als Fehlerfall gewertet und dann werden beispielsweise auch Bedienbefehle entsprechend den überdeckten Bedienelementen blockiert. Gegebenenfalls kann zusätzlich ein optisches und/oder akustisches Signal, beispielsweise ein Blinken an der Anzeige 24 oder ein lautes Piepsen, erzeugt werden.

Die Fig. 2 zeigt also einen möglichen Fall, wie mindestens ein Bedienelement 20, vorteilhaft mehrere, von Wasser oder Flüssigkeit allgemein bedeckt sein kann, was ungewollt verursacht worden ist. Hierauf wird nachher noch näher eingegangen bzw. darauf, was dann bei einem erfindungsgemäßen Verfahren getan werden kann.

Eine etwas andere Situation ist in der Fig. 3 dargestellt, bei der kein Kochwasser oder andere Flüssigkeit unbeabsichtigt auf die Oberseite der Kochfeldplatte 12 im Bereich der Bedieneinrichtung 18 oder der Bedienelemente 20 bis 23 gelangt ist. In diesem Beispielsfall möchte eine Bedienperson die Oberseite der Kochfeldplatte 12 mit einem feuchten Lappen abwischen, insbesondere zum Reinigen. Dazu betätigt sie in einem ersten Schritt mit einem Finger F den Wischschutz-Schalter 23 bzw. das entsprechende Bedienelement. Dies ist nur bei eingeschaltetem Kochfeld 11 möglich, aber auch nur dann wird eine solche Wischschutz-Funktion ja benötigt. Entweder kann direkt nach dem Aktivieren der Wischschutz-Funktion überprüft werden, ob mittels der Bedienelemente 20 bis 23 erkannt werden kann, ob ein feuchter Lappen und somit Flüssigkeit an sich oberhalb mindestens zwei der Bedienelemente 20 bis 23 oder oberhalb mindestens eines der Bedienelemente vorhanden ist. Hierfür kann vorteilhaft eine bestimmte Haltedauer vorgesehen sein, beispielsweise bis zu 5 sec, für die die Wischschutz-Funktion aktiviert bleibt, selbst wenn nichts an den Bedienelementen bzw. deren Sensorelementeinrichtungen erkannt wird. Dies weist den Vorteil auf, dass die Bedienperson nicht sofort und unmittelbar nach Aktivieren der Wischschutz-Funktion mit Wischen mit dem feuchten Lappen 28 beginnen muss, oberhalb der Bedienelemente 20 bis 23 die Kochfeldplatte 12 zu reinigen. Dies macht das Verfahren praxistauglicher. Würde dann innerhalb von 5 sec nichts festgestellt, so würde die Wischschutz-Funktion bereits deswegen wieder deaktiviert werden. Die vorgenannte Wartedauer beginnt ja eigentlich erst dann nach aktivierter Wischschutz-Funktion zu laufen, wenn an einem der Bedienelemente oder deren Sensorelementeinrichtungen eine Bedienung erkannt worden ist oder von diesen ein Sensorsignal empfangen worden ist.

Beginnt nun die Bedienperson mit dem feuchten Lappen 28 die Kochfeldplatte 12 zu reinigen, was einen Feuchtigkeitsfilm oben auf der Kochfeldplatte 12 erzeugt, so wird dies ja permanent an mindestens einem oder an mehreren der Bedienelemente 20 bis 23 erkannt. Die Bedieneinrichtung 18 bzw. deren Steuereinrichtung geht also davon aus, dass noch mit dem feuchten Lappen 28 gewischt wird, und so lange bleibt natürlich die Wischschutz-Funktion noch aktiviert. Es ist ja offensichtlich, dass diese Sensorsignale nicht von einer Bedienung herrühren.

Bei Betrachtung der Fälle der Fig. 2 und 3 kann also im Fall der Fig. 2 eine Bedienperson auch direkt nach Feststellen des Austretens von Kochwasser 26 über Bedienelemente die Wischschutz-Funktion noch am Wischschutz-Schalter 23 entsprechend Fig. 3 betätigen. Dann kann auch ausgehend von dem erkannten Fehlerfall aufgrund des Kochwassers 26 die Bedieneinrichtung 18 dieses Kochwasser 26 bzw. die davon an den Bedienelementen oder deren Sensorelementeinrichtungen erzeugten Signale ignorieren. Somit kann die Bedienperson beispielsweise die optische und/oder akustische Signalisierung des ausgelaufenen Kochwassers 26 deaktivieren, da dies häufig als störend empfunden wird. Des Weiteren schließt sich an diesen Fall üblicherweise das in Fig. 3 dann gezeigte Entfernen des Kochwassers 26 mit einem Lappen 28 an.

In der Fig. 4 ist dargestellt, wie sozusagen in einem dritten Schritt noch ein feuchter Bereich 30 oder Wasserfilm, der gestrichelt umrandet ist, durch das Wischen mit dem feuchten Lappen 28 als weitgehend entferntes Kochwasser 26 oder sonstige Feuchtigkeit vorhanden ist. Somit bleibt die Wischschutz-Funktion aktiviert.

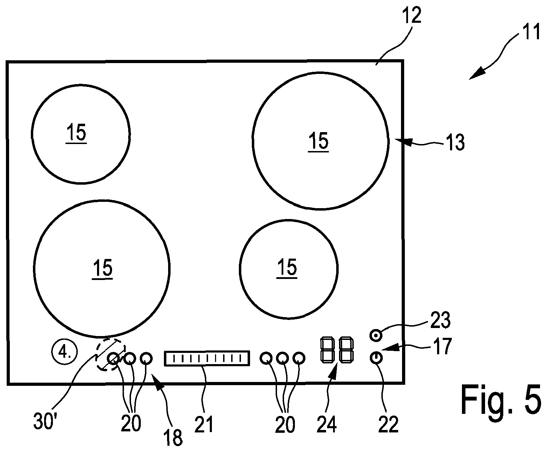

In einem vierten Schritt entsprechend der Fig. 5 ist der Wasserfilm des noch etwas größeren feuchten Bereichs 30 der Fig. 4 kleiner geworden und bedeckt als feuchter Bereich 30`, der wiederum gestrichelt dargestellt ist, nur noch das Bedienelement 30 ganz links. Hier kann nun in einer Ausgestaltung der Erfindung vorgesehen sein, dass die Steuereinrichtung der Bedieneinrichtung 18 die Wartedauer ablaufen lässt, wenn weniger als zwei Bedienelemente noch bedient sind oder Flüssigkeit über sich feststellen können. In diesem Fall kann die Wartedauer beginnen abzulaufen, und je nach ihrer Festlegung, beispielsweise auf 5 sec, kann nach Ablauf dieser 5 sec die Wischschutz-Funktion deaktiviert werden. Dann ist die normale Bedienung an der Bedieneinrichtung 18 wieder möglich.

In anderer Ausgestaltung der Erfindung kann vorgesehen sein, dass die Wartedauer abzulaufen beginnt, wenn bei aktivierter Wischschutz-Funktion gar kein Bedienelement mehr bedient wird bzw. über keinem Bedienelement mehr Flüssigkeit festgestellt werden kann. Dies ist dann eine nochmals strengere Unterscheidung, und im in Fig. 5 dargestellten Fall würde dann die Wartedauer noch nicht abzulaufen beginnen. Hierfür dürfte auch der letzte feuchte Bereich 30` über dem Bedienelement 20 nicht mehr vorhanden sein.

Wird nach Beginn des Laufens der Wartedauer, beispielsweise nach 3 sec, wenn die Wartedauer 5 sec beträgt, wieder eine Bedienung oder Flüssigkeit an mindestens einem Bedienelement oder an mindestens zwei Bedienelementen festgestellt, so gilt die Wischschutz-Funktion wieder als aktiviert bzw. sie bleibt aktiviert. Sämtliche Bedienungen außer am Ein-/Aus-Schalter 22 werden ignoriert, gegebenenfalls auch nicht am Wischschutz-Schalter 23. Erst wenn wieder über weniger als zwei Bedienelementen, möglicherweise über keinem Bedienelement, mehr eine Bedienung bzw. Flüssigkeit erkannt wird, beginnt die Wartedauer wieder zu laufen. Läuft sie dann ab, beispielsweise nach den vorgenannten vorgegebenen 5 sec, so wird die Wischschutz-Funktion deaktiviert.

So kann ein selbsttätiges Deaktivieren der Wischschutz-Funktion erreicht werden, sobald sie definitionsgemäß nicht mehr notwendig ist. Um hier auf Nummer sicher zu gehen, wird eben die Wartedauer vorgesehen, die Null betragen kann oder sehr kurz sein kann, aber auch bis zu 20 sec betragen kann.

In nochmals weiterer Ausgestaltung der Erfindung ist es vorstellbar, dass das Bedienelement des Wischschutz-Schalters 23 so wie auch der Ein-/Aus-Schalter 22 nicht von der Wischschutz-Funktion deaktiviert werden. So kann einerseits wie vorbeschrieben vorgesehen sein, dass die Wischschutz-Funktion unter bestimmten Bedingungen automatisch deaktiviert wird. Des Weiteren ist es dann aber für eine Bedienperson auch möglich, dass sie zusätzlich jederzeit manuell deaktiviert werden kann, beispielsweise weil sie nach Ansicht der Bedienperson nicht mehr notwendig ist.

Es ist leicht vorstellbar, dass anstelle des Betätigens des Wischschutz-Schalters 23 als einzigem Schalter mit einem Finger F entsprechend Fig. 3 auch zwei Bedienelemente bzw. Schalter oder mehr gleichzeitig oder kurz hintereinander betätigt werden müssen. Dann kann möglicherweise auch auf ein solches separates Bedienelement verzichtet werden, was den konstruktiven Aufwand verringert.

Des Weiteren kann vorgesehen sein, dass nicht eine vorgenannte Haltedauer implementiert ist, sondern dass nach Aktivieren der Wischschutz-Funktion in kurzer Zeit an einem Bedienelement bzw. seiner Sensorelementeinrichtung keine Flüssigkeit und keine Bedienung erkannt wird. So kann vorgesehen sein, dass nach einer Zeit zwischen 5 sec und 20 sec nach Aktivieren der Wischschutz-Funktion, wenn gar nichts erkannt wird, die Wischschutz-Funktion von der Bedieneinrichtung selbsttätigt deaktiviert wird. Dann war sie offensichtlich nicht notwendig, entweder weil gar nicht gewischt wurde oder zumindest nicht oberhalb der Bedieneinrichtung 18 oder ihrer Bedienelemente 20 bis 23 gewischt wurde.

## Patentansprüche

1. Verfahren zum Betrieb eines Kochfelds, wobei das Kochfeld aufweist:
- eine Kochfeldplatte,
- Heizeinrichtungen an der Kochfeldplatte,
- eine Bedieneinrichtung an bzw. unter der Kochfeldplatte, wobei die Bedieneinrichtung mehrere Sensorelementeinrichtungen unter der Kochfeldplatte aufweist um das Vorhandensein eines Fingers oberhalb einer der Sensorelementeinrichtungen auf der Oberseite der Kochfeldplatte für eine Bedienung zu erkennen, wobei die Sensorelementeinrichtungen auch dazu ausgebildet sind, das Vorhandensein von Flüssigkeit oberhalb einer Sensorelementeinrichtung auf der Oberseite der Kochfeldplatte zu erkennen und Sensorsignale zu erzeugen,
**dadurch gekennzeichnet, dass**:
- die Bedieneinrichtung eine Wischschutz-Funktion aufweist, die von einer Bedienperson aktivierbar und deaktivierbar ist,
- die Wischschutz-Funktion derart ausgebildet ist, dass nach Aktivieren der Wischschutz-Funktion Sensorsignale von den Sensorelementeinrichtungen von der Bedieneinrichtung nicht in Bedienbefehle umgesetzt werden oder keine Bedienung bewirken,
- die Wischschutz-Funktion erst dann von der Bedieneinrichtung selbsttätig wieder deaktiviert wird, wenn nach Aktivieren der Wischschutz-Funktion seit dem letzten Erkennen einer Bedienung an mindestens einer der Sensorelementeinrichtungen oder seit dem letzten Empfangen eines Sensorsignals von mindestens einer der Sensorelementeinrichtungen, das anzeigt, dass ein Finger oder Flüssigkeit auf der Oberseite der Kochfeldplatte oberhalb einer der Sensorelementeinrichtungen erkannt worden ist, eine Wartedauer von 0 sec bis 20 sec abgelaufen ist ohne erneutes Erkennen einer Bedienung oder Empfangen eines Sensorsignals.

2. Verfahren nach Anspruch 1, **dadurch gekennzeichnet, dass** die Wartedauer 1 sec bis 5 sec beträgt.

3. Verfahren nach Anspruch 1 oder 2, **dadurch gekennzeichnet, dass** die Wischschutz-Funktion für sämtliche Sensorelementeinrichtungen der Bedienvorrichtung gilt bis auf eine Sensorelementeinrichtung für eine Ein-/Ausschalt-Funktion des Kochfelds derart, dass eine Bedienung an dieser Sensorelementeinrichtung, vorzugsweise unabhängig davon, ob sie alleine oder gleichzeitig mit weiteren Sensorelementeinrichtungen bedient worden ist oder Sensorsignale von weiteren Sensorelementeinrichtungen empfangen worden sind, immer zum Einschalten oder Ausschalten des Kochfelds führt.

4. Verfahren nach einem der vorhergehenden Ansprüche, **dadurch gekennzeichnet, dass** ein Aktivieren der Wischschutz-Funktion von der Bedieneinrichtung signalisiert wird, insbesondere akustisch und/oder optisch signalisiert wird.

5. Verfahren nach einem der vorhergehenden Ansprüche, **dadurch gekennzeichnet, dass** ein Deaktivieren der Wischschutz-Funktion von der Bedieneinrichtung signalisiert wird, insbesondere akustisch und/oder optisch signalisiert wird, vorzugsweise gleichartig wie beim Aktivieren der Wischschutz-Funktion nach Anspruch 4.

6. Verfahren nach einem der vorhergehenden Ansprüche, **dadurch gekennzeichnet, dass** die Wischschutz-Funktion durch Bedienen einer einzigen Sensorelementeinrichtung aktiviert wird.

7. Verfahren nach einem der Ansprüche 1 bis 5, **dadurch gekennzeichnet, dass** die Wischschutz-Funktion durch gleichzeitiges Bedienen von mindestens zwei Sensorelementeinrichtungen aktiviert wird.

8. Verfahren nach einem der vorhergehenden Ansprüche, **dadurch gekennzeichnet, dass** die Wischschutz-Funktion an der Bedieneinrichtung auf dieselbe Art und Weise durch eine Bedienperson deaktivierbar ist wie sie aktivierbar ist.

9. Verfahren nach einem der vorhergehenden Ansprüche, **dadurch gekennzeichnet, dass** nach 2 min bis 20 min nach Aktivieren der Wischschutz-Funktion ohne Erkennen eines Bedienens an mindestens einer Sensorelementeinrichtung oder Empfangen eines Sensorsignals von mindestens einer Sensorelementeinrichtung bezüglich Erkennens von Wasser darüber, vorzugsweise von mindestens zwei Sensorelementeinrichtungen bezüglich Erkennens von Wasser darüber, die Wischschutz-Funktion von der Bedieneinrichtung selbsttätig deaktiviert wird.

10. Verfahren nach einem der vorhergehenden Ansprüche, **dadurch gekennzeichnet, dass** die Wischschutz-Funktion nur dann aktiv bleibt, wenn nach ihrem Aktivieren innerhalb der Wartedauer mindestens zwei Sensorelementeinrichtungen bedient werden oder Sensorsignale von mindestens zwei Sensorelementeinrichtungen, insbesondere gleichzeitig, empfangen werden.

11. Kochfeld mit:
- einer Kochfeldplatte,
- Heizeinrichtungen an der Kochfeldplatte,
- einer Bedieneinrichtung an bzw. unter der Kochfeldplatte, wobei die Bedieneinrichtung mehrere Sensorelementeinrichtungen unter der Kochfeldplatte aufweist, um das Vorhandensein eines Fingers oberhalb einer der Sensorelementeinrichtungen auf der Oberseite der Kochfeldplatte für eine Bedienung zu erkennen,
- einer Steuereinrichtung in der Bedieneinrichtung, die dazu ausgebildet ist, die Sensorelementeinrichtungen anzusteuern und auszuwerten,
- ggf. einer Signaleinrichtung in der Bedieneinrichtung,
wobei die Sensorelementeinrichtungen dazu ausgebildet sind, eine Bedienung mittels eines Fingers und vorzugsweise das Vorhandensein von Flüssigkeit oberhalb einer Sensorelementeinrichtung auf der Oberseite der Kochfeldplatte zu erkennen, ggf. zusammen mit der Steuereinrichtung und zusätzlichen Sensoren, und Sensorsignale zu erzeugen zum Durchführen des Verfahrens nach einem der vorhergehenden Ansprüche.

12. Kochfeld nach Anspruch 11, **dadurch gekennzeichnet, dass** das Kochfeld eine Steuereinrichtung in der Bedieneinrichtung aufweist, die die Sensorelementeinrichtungen ansteuert und auswertet, sowie ggf. auch eine Signaleinrichtung aufweist.
